# EUROPEAN PATENT APPLICATION

(11) **EP 1 106 843 A1**
(43) Date of publication of application: **13.06.2001**
(21) Application number: 00660220.5
(22) Date of filing: 04.12.2000
(51) Int. Cl.: F16B 11/00

(54) **Duct and method for forming the same**

(30) Priority: 08.12.1999 FI 992634
(71) Applicant: ABB Industry Oy, 00381 Helsinki (FI)
(72) Inventor: Kauranen, Matti, 02710 Espoo (FI)
(74) Representative: Lipsanen, Jari Seppo Einari

(57) **Abstract**

The invention relates to a method for forming a duct, to a duct, and to a duct component intended to form the duct, by means of which it is possible to form, for example, cooling systems for electronic components. In the method, in such a duct intended to conduct a flowing pressurized substance such as a cooling liquid, a heating liquid, or a gas, which has a base component (2) formed from a stiff material and a duct component (1) formed from a more flexible material than the base component, a sealing lip (4) is formed, which protrudes towards the opposite wall of the duct component in such a way that the sealing lip runs round all the duct walls that are in contact with the stiff material, i.e. parallel to the longitudinal axis in elongated ducts, is formed.

## Description

The present invention relates to a method, according to the preamble to Claim 1, for manufacturing a duct to be made from a stiff base material and a flexible duct material.
The duct may be a cooling duct, a heating duct, or some other duct intended to conduct a flowing pressurized material.

The invention also relates to a duct and a duct component to be used to form the duct.

Adhesive, or more simply glued connections have several benefits. Many different kinds of pieces can be economically manufactured by gluing. An important benefit is that gluing can be used to economically attach components made from different materials to each other, while the joint does not require the components to be worked on during attachment. The weak point in such joints is the glued interface. A glued joint can fail through three different mechanisms - tensile failure, peeling, and fracture. Tensile failure occurs if the surface area of the glued joint is too small relative to the surface area of the upper part of the ducts, i.e. so that the stress placed on the joint is greater than it can withstand. Failure of this kind is usually due to a incorrect dimensioning, operating conditions, or manufacturing faults in the joint. A general rule in cooling ducts is that the smaller the size of the duct, the smaller the tensile stresses caused by the pressure in them. Of course, at some stage, the size of the duct, i.e. the smallest possible dimension of the duct, is limited by the flow resistance (which also depends on the length of the ducts) and manufacturing considerations. Peeling is due to adhesive weakness in the glued joint. Using the smallest duct possible also helps to prevent peeling. Another significant factor is the glue's peeling strength and elasticity and their change over time. Though the fracture of a glued joint is closely associated with peeling, as a phenomenon it depends on the glue. The significant parameters are not only the strength and elasticity of the glue, but also the thickness of the glued joint. In general, it can be said that the thinner the glued joint, the better its fracture strength. The optimal thickness of structural glues is generally regarded as being 0.05 - 0.10 mm.

Glues are much more liable to peel than to fail under tension. For example, the tensile failure strength of epoxy glues is in the range 15 - 45 N/mm, whereas their peeling strengths vary between 1 - 4 N/mm². Thus, the kind of loading acting on a joint greatly affect the strength and durability of the joint. However, the shape of the pieces to be joined and the product to be manufactured limit the shaping of the joint area, preventing the optimization of the stresses acting on the joint.

The invention is intended to create an entirely new type of method and cooling duct, which allow the type of stress and level of stress acting on the glued joint to be varied to better suit glued-joint technology.

The invention is based on forming a sealing lip in the sides of the duct component of a duct intended to conduct a flowing pressurized substance, such as a cooling liquid, a heating liquid, or a gas, the base component of the duct being formed of a stiff material and the duct component of a more flexible material, with the sealing lip protruding towards the opposite wall of the duct in such a way that it runs round all the sides that make contact with the stiff material, i.e. in a longitudinal direction in elongated ducts.

According to one preferred embodiment, the surface of the lip point away from the stiff base component forms an angle of 0 - 30° with the surface of the base component.

More specifically, the method according to the invention for forming a duct is characterized by what is stated in the characterizing section of Claim 1.

The duct according to the invention is, in turn, characterized by what is stated in the characterizing section of Claim 5.

The duct component according to the invention is characterized by what it stated in the characterizing section of Claim 12.

Considerable advantages are gained with the aid of the invention.

The invention can be used to substantially reduce the forces acting on the glued joint and to level the stress peaks in the joint. Thus, the joint will be more durable or it can be dimensioned to be smaller than before. It will better withstand ageing and weakening, i.e. fatiguing due to dynamic stress, as the stress level is lower and there are fewer of the detrimental stress peaks characteristic of during dynamic stress. The fracture mechanism of the glued seam is changed to a tensile fracture, whereby the glue is stressed in a way it can best withstand. The invention's advantages give a service age in the glued joint and a maximum permitted liquid pressure many times those of similarly dimensioned duct solutions without sealing lips. In addition, parallel cooling ducts can be placed closer together.

In the following, the invention is examined with the aid of examples and with reference to the accompanying drawings.

Figure 1 shows one duct according to the invention.

Figure 2 shows one duct component according to the invention.

Figure 3 shows the stress distribution in a conventional duct.

Figure 4 shows the stress distribution in a duct according to the invention.

In the following, the terms stiff or flexible material refer to the relative properties of the materials, such as materials classified as stiff or flexible according to their modulus of elasticity. Naturally, the actual stiffness of pieces depends on their dimensioning.

The duct construction according to the invention comprises a duct component 1, with a base component attached to it adhesively, and which can be made from, for example, steel. Duct component 1, has a liquid duct 3 for a flowing pressurized liquid. Liquid duct 3 has two sealing lips 4 formed in its longitudinal sides, on both walls of the duct. Sealing lips 4 protrude towards the duct's centreline 6, in such a way that a gap 7 remains between them, through which the substance in the duct, for example, a cooling liquid, comes in contact with the base component. The duct is thus a groove in the surface of the separate duct component 1. The width of the sealing lip towards the centreline of duct 3 and its height can be, for instance, the thickness of the base component, i.e. if a 1-mm plate is used in the base component, the overall outer dimensions of the sealing lip would be 1 x 1 mm. This example of dimensioning corresponds to a duct with a 4 x 4-mm cross-section.

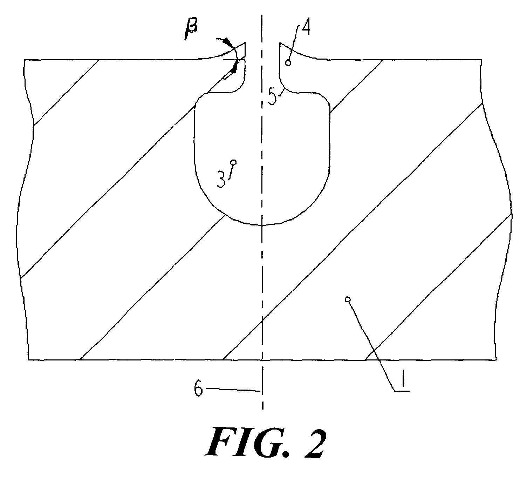

Sealing lip 4 is preferably higher on the side next to the centreline 6 of duct 3 than on the side next to the wall of duct 3, i.e. a ridge 5 is formed in lip 4, with a corresponding groove 8 on the wall side of duct 3. An angle α is then formed between the surface of sealing lip 4 pointing away from base component 2 and the surface of base component 2 facing duct component 1. This angle (α), which can typically vary from 0 to 30 degrees depending on the method of manufacture and the application, is particularly important in the shaping of sealing lip 4. The angle levels the forces caused by the pressures in the duct. The most difficult aspect of the manufacturing technique of the method according to the invention relates to the area of the adhesive joint of sealing lip 4, as, when the components are pressed against each other during gluing, the surface pressure at lip 4 should be the same as elsewhere, so that, for example, the thickness of the glue layer and the behaviour of the glue during gluing will be the same over the entire area of the joint. To ensure the success of the gluing, it is preferable to manufacture lip 4 as shown in Figure 2. Duct component 1, or some other flexible component is then shaped so that before gluing the lip points up, at an angle of a few degrees, from the surface of the open side of the duct of duct component 1. The angle β then helps to define the lip's internal angle α. Angle β may be 3 - 30 degrees, depending on the rubber composition or the properties of any other material being used. Sufficient pressure can then also be ensured in the area of the lip, when gluing the pieces. Alternatively, it is possible to envisage supporting the lip by pressurizing the duct or placing a support member in it, but this is often difficult, due to the complex shape of the ducts.

A duct according to the invention is manufactured so that grooves are formed in the surface of the flexible duct component, in which there are sealing lips, similar to those described above, in the sides of the grooves. The duct component is attached adhesively to the stiff base component, so that the base component closes the grooves in the duct component to form ducts. The ducts may be only open at the ends, or they may have forks.

The functionality of the solution according to the invention is estimated by calculation by modelling a duct shape previously used and one duct shape according to the invention. The FEM (Finite Element Method) calculations performed with the following models show the advantages of the invention. The ducts of the models have equally large thermal transfer capacities, i.e. equal contact surface areas between the flowing pressurized liquid and the stiff component. The calculations were carried out using Ansys ED 5.4-FEM software.
- MODEL 1:: - circulation section duct, radius of bottom R = 1.0 mm, i.e. duct width 2.0 mm
- base component 0.75-mm steel plate, modulus of elasticity E = 210 Gpa
- 5.0-mm thick duct component, E = 15 GPa
- pressure in duct 10 bar

The distribution of the stress level in Model 1 predicts peeling or glued-joint failure. The greatest stress acts on the edge of the glued joint.
- MODEL 2:: - shaped duct, width of duct below steel plate 2.0 mm, duct width 4.0 mm
- base component 0.75-mm steel plate, E = 210 Gpa
- 5.0-mm thick duct component, E = 15 Gpa
- pressure in duct 10 bar

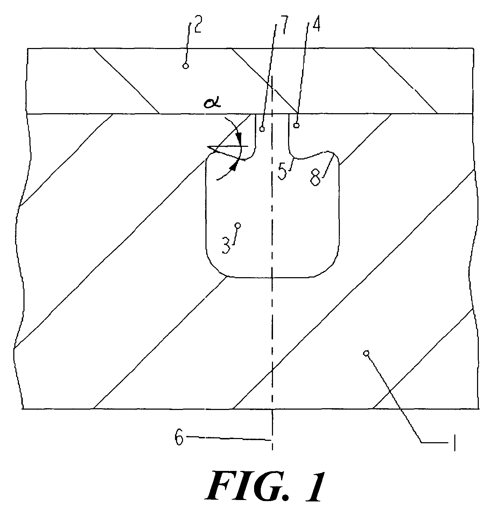

In Model 2, the stress level and stress peaks have dropped significantly compared to Model 1. In addition, the change in stress of the glued joint has changed the predicted failure mechanism from peeling or fracture to tensile failure. The stress peaks would probably be levelled even more, if the duct geometry incorporated rounded corners according to Figure 1.

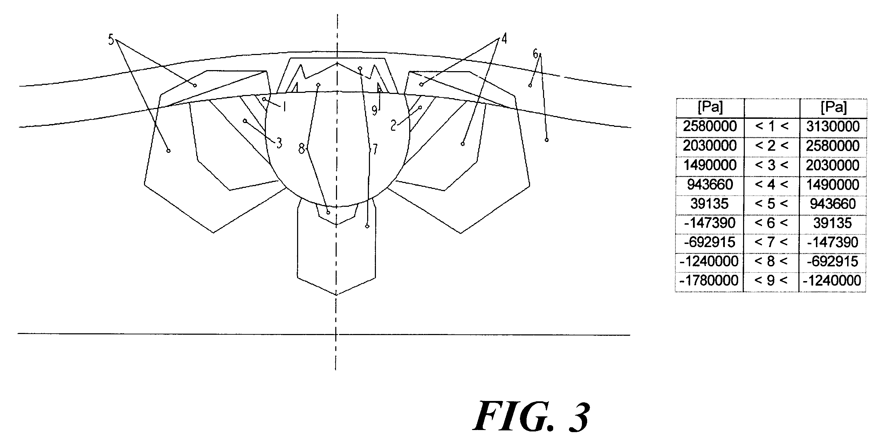

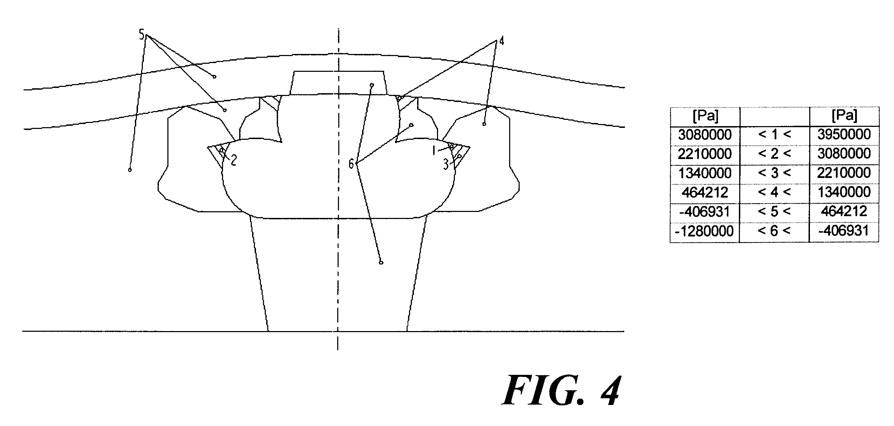

Figures 3 and 4 show the stress distributions in the surroundings of the ducts. The areas marked with numbers depict the stress values in Pascals shown in the tables of the figures.

This analysis was carried out according to Hooke's stress-strain law, which leads to a significant calculative weakness in the calculation in the above example. It is generally recognized that Hooke's law does not apply to flexible materials. However, this calculative weakness has no effect on the use of the sealing lip to alter the level of stress, reduce the stress peaks, and change the failure mechanism. Hooke's law, however, significantly affects the magnitude of the stress level. The above stress levels must be regarded rather as indicative than as precisely calculated values.

Embodiments of the invention, differing from those disclosed above, can also be envisaged within the scope of the invention. For the sake of simplicity, the above example shows only a single duct. In practice, in cooling pieces for example, there are as many ducts as possible within a specific surface area. In other applications and constructions, the number and shape of the ducts may of course vary. Particularly if the duct component is closed, so that the liquid or other flowing substance is led through the stiff component through a pipe connector or similar, the sealing lips must be adapted to the sides of the duct at the connection in such a way that the sealing lip runs round all the walls of the bank of ducts that are in contact with the stiff material. Pipe connectors are the most natural way to implement this.

The material of the base component may be other than steel, but the stiffness of steel is good relative to its thermal conductivity, making it highly suitable for the manufacture of such cooling ducts. Other materials that can be envisaged include copper, aluminium, and their various alloys. The flexible duct component can be of rubber or a flexible polymeric material. The sealing lip can be formed in many ways. One possible way of manufacturing it is to divide the duct component into two, between the sealing lip and the bottom of the bank of ducts. The duct components are glued, vulcanized, or otherwise joined together chemically. The division can be made in such a way that the sealing lips are formed in a thin mat-like piece, to which the bottom part of the said bank of ducts is attached, or by dividing the duct component along the centreline of the duct. In terms of manufacturing technique, materials other than rubber can be used. For example, it is possible to use flexible thermoplastics, which are attached to each other by thermal gluing. In thermoplastics, the lip also need not be turned away from the duct, if it is possible to ensure sufficient pressure in the area of the lip, when gluing the base component. The rubber duct components can be manufactured, for example, by injection or compression moulding.

## Claims

1. A method for manufacturing at least one duct, in which method:
- a duct component (1), which includes at least one elongated duct groove (3) in the surface of the component (1), is formed from a flexible material, and
- the duct component (3) is attached adhesively to a stiff base component (2) in such a way that the base component (2) closes the duct groove, to form an elongated duct (3),
**characterized** in that
- at least one sealing lip (4), which protrudes towards the opposite wall of the duct component, is formed in the duct groove (3) of the duct component (3), so that the sealing lip (4) runs round all the duct walls that are in contact with the stiff material.

2. A method according to Claim 1, **characterized** in that the sealing lips (4) are formed by injection or compression moulding.

3. A method according to Claim 1, **characterized** in that the sealing lips (4) are formed by attaching the part including the lips to the part including the duct.

4. A method according to Claim 1, **characterized** in that the duct component is formed from two parts, which are joined together and in which there are lip components that are symmetrical in relation to the centreline of the duct groove.

5. A duct, which includes a stiff base component (2) and a flexible duct component (1) attached adhesively to the base component (2), in which there is at least one duct groove (3) opening out onto the surface of the base component, **characterized** in at least one sealing lip (4) on the side of the duct groove (3) of the duct component (1), and which protrudes towards the opposite wall of the duct component in such a way that the sealing lip (4) runs round all the duct walls that are in contact with the stiff material.

6. A duct according to Claim 5, **characterized** in that the surface of the sealing lip (4) that points away from the stiff base component forms an angle (α) of 0 - 30°, in relation to the base component's surface against the duct component.

7. A duct according to Claim 5, **characterized** in that the duct component (1) is manufactured in two parts.

8. A duct according to Claim 7, **characterized** in that the duct component is divided in such a way that the sealing lips (4) and duct groove are in separate pieces.

9. A duct according to Claim 7, **characterized** in that the duct component is divided along the centreline (6) of the duct groove.

10. A duct according to one of Claims 5 - 7, **characterized** in that the stiff base component (2) is of metal and the flexible duct component (1) is of rubber.

11. A duct according to one of Claims 5 - 7, **characterized** in that the stiff base component (2) is of metal and the flexible duct component (1) is of plastic polymer.

12. A duct component (1), which includes at least one groove (3) formed in its surface, **characterized** by a sealing lip (4) in at least one of the sides of the duct groove (3), which protrudes towards the opposite wall of the duct component in such a way that the sealing lip (4) runs round all the walls of the duct that are in contact with the stiff material, and which is turned outwards from the surface onto which the duct groove (3) opens.

13. A duct component according to Claim 12, **characterized** in that the upward angle (β) of the sealing lips (4) from the surface is 3 - 30°.
